(19) Europäisches Patentamt / European Patent Office / Office européen des brevets

(11) **EP 3 223 023 B1**

(12) **EUROPEAN PATENT SPECIFICATION**

(45) Date of publication and mention
of the grant of the patent:
**04.12.2019 Bulletin 2019/49**

(51) Int Cl.:
**G01R 27/26** (2006.01)  **G05B 13/04** (2006.01)
**H02M 7/527** (2006.01)

(21) Application number: **16162278.2**

(22) Date of filing: **24.03.2016**

(54) **METHOD AND APPARATUS FOR ESTIMATING CAPACITANCE OF DC LINK**

VERFAHREN UND VORRICHTUNG ZUR SCHÄTZUNG DER KAPAZITÄT EINES
GLEICHSPANNUNGSZWISCHENKREISES

PROCÉDÉ ET APPAREIL D'ESTIMATION DE LA CAPACITÉ DE D'UNE LIAISON CC

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**27.09.2017 Bulletin 2017/39**

(73) Proprietor: **ABB Schweiz AG
5400 Baden (CH)**

(72) Inventors:
• **Kukkola, Jarno
  02650 Espoo (FI)**
• **Hinkkanen, Marko
  02650 Espoo (FI)**

(74) Representative: **Kolster Oy Ab
(Salmisaarenaukio 1)
P.O. Box 204
00181 Helsinki (FI)**

(56) References cited:
**DE-A1-102013 217 875     JP-A- 2001 309 561
KR-B1- 101 553 480     KR-B1- 101 605 990**

EP 3 223 023 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The invention relates to voltage-source converters, and particularly to estimation of capacitance of a DC link in a voltage-source converter.

BACKGROUND

Voltage-source grid-connected converters are widely used for AC-to-DC and DC-to-AC power conversion in various applications, such as electric motor drives, electric vehicles, and renewable energy generation. DC-link capacitors or capacitor banks of these converters play an important role working as energy buffers and balancing the DC voltage variations. However, capacitors are among the most fragile electronic components in converters. A typical reason for a capacitor failure is the long-term wear-out, which may be observed as a change of electrical parameters of the capacitor. Thus, monitoring electrical parameters of the capacitor may provide information of the capacitor condition. The condition of a capacitor may be monitored by estimating or measuring the capacitance of the capacitor, for example. The capacitance is typically reduced at the end of the lifetime of the capacitor. In some cases, estimation methods may be preferred since the measurement methods often require additional equipment (e.g. sensors) that may be expensive.

There are various methods for estimating a DC-link capacitance. For example, in electric drives connected to electric motors, the capacitance may be estimated by discharging the capacitor energy to the stator winding of the motor when the motor is stopped. The capacitance is then estimated based on a change detected in the charge of the capacitor. However, this approach cannot be used in applications where the motor does not exist, e.g. in solar inverters. For the case of solar inverters, JP2001309561 proposes to measure the DC link voltage, the DC link current and the capacitor current and to estimate the capacitance based on a Least Square algorithm. Alternatively, the capacitor may be discharged with a braking circuit in the converter. The capacitance may also be estimated by monitoring a decreasing voltage while the capacitor bank energy is being discharged through trimming resistors parallel to the capacitors of the capacitor bank. However, these approaches cannot be used during the normal operation of the converter.

Another approach for estimating the capacitance uses a ripple voltage and current of the capacitor during use as an input signals for a Kalman filter. A drawback of the ripple-voltage based methods is that measurement system, including sensors, may have to have a high bandwidth in order to be able to capture ripple waveforms deriving from the pulse-width modulation. In addition, the high-bandwidth measurements may be sensitive to noise and the sensors may be more expensive.

Yet another approach for estimating the capacitance is based on injecting low-frequency sinusoidal current to a control reference of a converter so that the injection signal causes oscillations to the voltage of the capacitor. The oscillatory component of the DC-voltage may be extracted by filtering the voltage with a band-pass filter. The capacitance is estimated on the basis of the extracted oscillatory component and the current of the capacitor. However, the addition of the injection signal to the control reference and the use of the band-pass filter for determining the oscillatory component may significantly increase the complexity of the control system. The estimation of the capacitance of DC link capacitors in voltage source inverters based on signal injection and by solving a regression problem based on Least Square algorithms is a subject of KR101605990 and KR101553480.

BRIEF DESCRIPTION

An object of the present disclosure is to provide a method and an apparatus for implementing the method so as to alleviate the above disadvantages. The objects of the invention are achieved by a method and an arrangement which are characterized by what is stated in the independent claims 1 and 11. The preferred embodiments of the invention are disclosed in the dependent claims.

The present disclosure describes a method for estimating the capacitance of the DC-link capacitor of a converter. During an observation period of the method, the normal control loop of the converter may be bypassed, and a simple excitation signal for the capacitance identification may be fed to the converter current or power reference. By determining magnitudes of the changes in the energy and voltage of the DC link induced by the excitation signal, the capacitance of the DC link can be determined. While the excitation signal is used as the reference, the DC-link voltage and phase currents of the converter may be measured and stored together with an output voltage reference of the modulator of the converter, for example. The capacitor energy may be calculated on the basis of the phase currents and the output voltage reference, and the capacitance may be estimated by using the measured DC-link voltage and the calculated capacitor energy as input signals for a least-squares estimator, for example.

The estimation of the capacitance can be carried out during the normal operation or at the startup of the converter. The method according to the present disclosure enables online tracking of the DC-link capacitance that is useful in condition monitoring of the capacitors and predictive maintenance before the capacitance failure. The method also enables adaptive tuning of the control system, e.g., the DC-link voltage controller, since the capacitance estimation may be repeated during the converter operation. The method can be easily implemented to a typical grid-connected converter, e.g. a solar inverter, or to an active-front-end rectifier of a motor drive. No hardware modifications are needed, and only minor changes in the converter-control software are required.

BRIEF DESCRIPTION OF THE DRAWINGS

In the following the invention will be described in greater detail by means of preferred embodiments with reference to the attached drawings, in which

Figure 1 shows an exemplary power flow diagram of an equivalent circuit of a grid-connected converter;
Figure 2 shows an exemplary control system of a voltage-source converter to which the excitation signal of method according to the present disclosure can be applied;
Figures 3a and 3b show two exemplary excitation signals having two or three pulses of different sizes and lengths; and
Figure 4 shows an exemplary excitation signal according to the present disclosure during normal operation of a voltage-source converter.

DETAILED DESCRIPTION

The present disclosure describes a method for estimating a capacitance of a DC link of a three-phase voltage-source converter. The voltage-source converter may be configured to supply a grid from a DC source, for example.
The voltage-source converter comprises means for controlling a power flow of the DC link responsive to a control reference. In this context, the power flow of the DC link (in a shorter form, DC link power flow) represents a difference between a first power flowing to the DC link and a second power flowing out from the DC link.

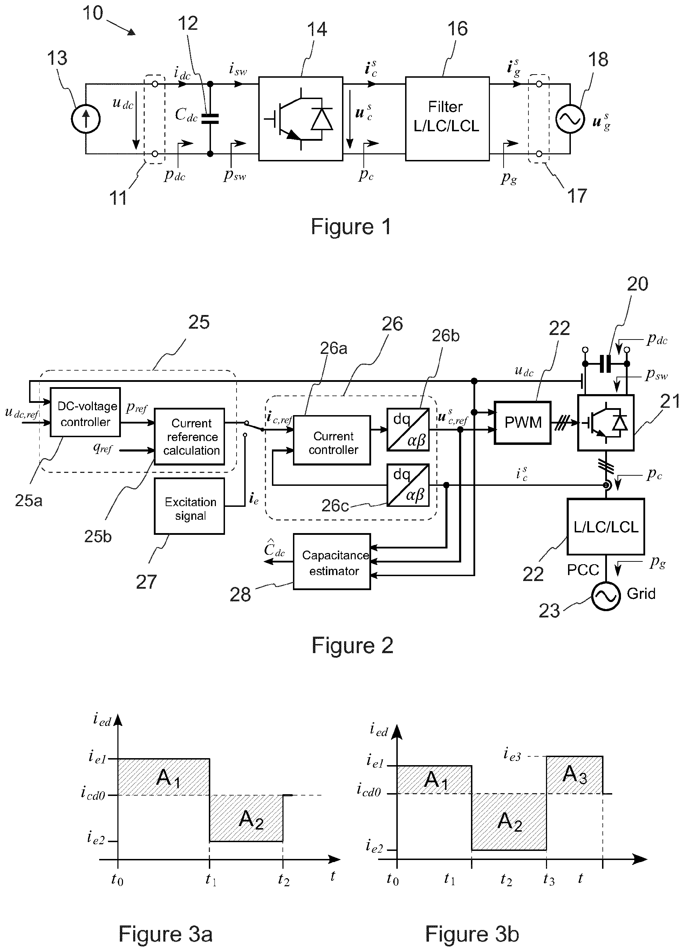

Figure 1 shows an exemplary, equivalent power flow diagram of a three-phase, grid-connected converter. The converter 10 in Figure 1 comprises a DC-side connection 11, a DC link 12, a semiconductor bridge 14, and a grid-side filter 16, and an AC-side connection 17 through which the converter 10 is connected to a grid 18. Figure 1 shows voltages, currents, and powers associated to the power flow. The positive power direction is selected to correspond with the flow of power of a converter operating as an inverter mode (i.e. converting DC power into AC power). In Figure 1, an external power $p_{dc}$ supplies the DC link 12 through the DC-side connection 11, and thus acts as the first power flowing to the DC link 12. In Figure 1, the external power $p_{dc}$ is provided by a DC power source 13. The DC power source may be one or more solar panels, for example. The external power $p_{dc}$ may be calculated as follows, for example:

$$p_{dc} = u_{dc}i_{dc}, \tag{1}$$

where $u_{dc}$ is the DC-link voltage and $i_{dc}$ is the direct current of the external DC power source. A DC-side converter power $p_{sw}$ (acting as the second power) flows out from the DC link to the semiconductor bridge 14. The semiconductor bridge 14 may be an inverter bridge comprising semiconductor switches, for example. The converter 10 uses the semiconductor bridge 14 to convert the DC-side converter power $p_{sw}$ into an AC-side converter power $p_c$.
The quantities in Figure 1 are assumed to be averaged over a switching-cycle. Complex-valued space vectors are marked with boldface symbols. The converter output power may be calculated as

$$p_c = \frac{3}{2}\mathrm{Re}\left\{\boldsymbol{u}_c^s \boldsymbol{i}_c^{s*}\right\} = \frac{3}{2}\mathrm{Re}\left\{\boldsymbol{u}_c \boldsymbol{i}_c^*\right\} \tag{2}$$

where $\boldsymbol{u}_c^s$ is the converter voltage and $\boldsymbol{i}_c^s$ is the converter current in stationary coordinates and $\boldsymbol{u}_c$ and $\boldsymbol{i}_c$ are the corresponding quantities in synchronous coordinates. The complex conjugate is denoted by superscript *. The relation between the DC-side converter power $p_{sw}$ and the AC-side converter power $p_c$ may be represented as follows, for example:

$$p_{sw} = p_c + p_l, \tag{3}$$

where $p_l$ represents conversion losses induced in the semiconductor bridge 14.

In some applications, the converter voltage $\boldsymbol{u}_c^s$ may not be measured so Equation (2) may not be directly utilizable. However, the AC-side converter power $p_c$ may be calculated on the basis of a voltage reference $\boldsymbol{u}_{c,ref}^s$ for a modulator of the voltage-source converter and the output current $\boldsymbol{i}_c^s$ of the voltage-source converter, for example:

$$p_c = \frac{3}{2}\mathrm{Re}\left\{\boldsymbol{u}_{c,ref}^s\left(t-T_s\right)\boldsymbol{i}_c^{s*}\left(t\right)\right\}, \qquad (4)$$

where $T_s$ is the sampling time, and the one-sample delay $\left[\boldsymbol{u}_c^s\left(t\right) = \boldsymbol{u}_{c,ref}^s\left(t-T_s\right)\right]$ is considered because of the finite computation time of the control algorithm.

The DC-side converter power $p_c$ is supplied through the grid-side filter 16 to the grid 18. The power fed into the grid is $p_g$ in Figure 1.

The dynamics of the DC-link voltage may be defined as follows:

$$C_{dc}\frac{du_{dc}}{dt} = i_{dc} - i_{sw}, \qquad (5)$$

where $C_{dc}$ is the capacitance and $i_{sw}$ is a current from the DC link to the semiconductor bridge. Multiplying both sides of Equation (1) by the DC link voltage $u_{dc}$, the following capacitor-energy dynamics may be obtained:

$$\frac{d}{dt}\underbrace{\left(\frac{1}{2}C_{dc}u_{dc}^2\right)}_{W} = p_{dc} - p_{sw}, \qquad (6)$$

where

$$W = \frac{1}{2}C_{dc}u_{dc}^2 \qquad (7)$$

represents the energy stored in the capacitor, and $p_{dc} - p_{sw}$ represents the power flow of the DC link. In the integral form, the energy $W$ during an observation period $0 \leq t \leq t_e$ may be represented as an integral of the DC link power flow:

$$W(t) = \int\left[p_{dc}\left(t\right) - p_{sw}\left(t\right)\right]dt + W_0, \qquad (8)$$

where $W_0$ is the initial energy stored in the capacitor at the beginning of the observation period ($t = 0$).

During the observation period $0 \leq t \leq t_e$, the external power $p_{dc}(t)$ acting as the first power in Figure 1 may be assumed to remain constant at an initial external power level $p_{dc}0$ (i.e. $p_{dc}(t) = p_{dc0}$). The initial external power level $p_{dc0}$ represents the level of the external power $p_{dc}(t)$ at the beginning of the observation period ($t = 0$). Further, power losses of the DC link capacitor 12 may be considered negligible so that the initial level $p_{dc0}$ at corresponds to an initial power level $p_{sw0}$ of the DC-side converter power $p_{sw}(t)$ at the beginning of the observation period (i.e. $p_{dc0} - p_{sw0} \approx 0$). Thus, the external power can be written as $p_{dc}(t) \approx p_{sw0}$. In other words, the initial level of the second power may be used as a basis for approximating the level of a constant first power. Moreover, considering Equation (2), the external power becomes $p_{dc}(t) = p_{c0} + p_{l0}$, where $pc_0$ represents an initial level of the AC-side converter power and $p_{l0}$ represents an initial level of the power losses of the semiconductor bridge. Then, together with Equation (2), the energy $W$ of the capacitor can be written

$$W(t) = \int\left[p_{c0} + p_{l0} - p_c\left(t\right) - p_l\left(t\right)\right]dt + W_0. \qquad (9)$$

Furthermore, assuming that converter losses are constant (i.e. $p_l(t) = p_{l0}$) during the observation period $0 \leq t < t_e$, Equation (9) may be simplified into

$$W(t) = \int \left[ p_{c0} - p_c(t) \right] dt + W_0 , \qquad (10)$$

where $p_{c0}$ can be considered as an approximation of the first power flowing to the DC link, and $p_c(t)$ can be considered as an approximation or the second power flowing out of the DC link.

For the identification of the capacitance, an energy difference term $\Delta W = W - W_0$ may introduced. The energy difference obtained from (7) is

$$\Delta W(t) = \frac{1}{2} C_{dc} \left[ u_{dc}^2(t) - u_{dc0}^2 \right] , \qquad (11)$$

where $u_{dc0}$ represents an initial capacitor voltage at the beginning of the observation period ($t = 0$). At the same time, the integral (10) directly gives

$$\Delta W(t) = \int \left[ p_{c0} - p_c(t) \right] dt . \qquad (12)$$

Together, the energy differences formulate a linear equation

$$C_{dc} \underbrace{\frac{1}{2} \left[ u_{dc}^2(t) - u_{dc0}^2 \right]}_{y(t)} = \underbrace{\int \left[ p_{c0} - p_c(t) \right] dt}_{x(t)} . \qquad (13)$$

Based on Equation (13), the capacitance $C_{dc}$ can be determined. However, in order to have a meaningful value for the capacitance, a change may have to be induced to the power flow of the capacitor. In order to control a temporary change to the power flow, an excitation signal with a plurality of levels of the power flow may be generated and the excitation signal may be temporarily used as the control reference.

The excitation signal induces a temporary change to the DC link power flow during an observation period. A voltage response induced to the DC link voltage by the temporary change in the power flow may be monitored, and a change in energy stored in the DC link caused by the temporary change in the power flow may be calculated.

Monitoring the voltage response may comprise sampling the DC link voltage in order to determine the voltage response during an observation period. A first set $y(k)$ of data points may be formed on the basis of the voltage response. Each data point in the first set $y(k)$ may represent a difference between a square of a sampled DC link voltage and a square of an initial value of the DC link voltage at the beginning of the observation period, for example. The calculation of the change in the energy stored in the DC link may comprise calculating values of the power flow during the observation period. A second set $x(k)$ of data points may be formed on the basis of the calculated values. Each data point of the second set $x(k)$ may represent an integral of the calculated values of the power flow of the DC link.

Each data point of the first set may be coupled to a data point of the second set. Thus, each data point in the first set may have a data point sampled at the same time instant in the second set. The energy difference may be modelled on the first set and the second set. For example, the following discrete-time model may be used:

$$y(k) = \beta x(k) + v(k), \qquad (14)$$

where the first set $y(k)$ of data points is

$$y(k) = 0.5 \left[ u_{dc}^2(k) - u_{dc0}^2 \right] . \qquad (15)$$

$x(k)$ is the second set of data points, $k$ is the discrete-time index, and $\beta = 1/C_{dc}$ is the model parameter. A measurement noise is included in $v(k)$.

The calculation of the second set may depend on the application. In Figure 1, the external power is assumed to have a constant, predetermined value during the observation period. The integral for input signal x may be represented calculated on the basis of the sampled data by using a simple Euler approximation:

$$x(k+1) = x(k) + T_s [p_{c0} - p_c(k)], \qquad (16)$$

where $T_s$ is the sampling time of the discrete model. Values for the AC-side converter power $p_c$ may be calculated on the basis of the output voltage $\boldsymbol{u}_c^s$, or a voltage reference $\boldsymbol{u}_{c,ref}^s$ for the modulator, and the output current $\boldsymbol{i}_c^s$ of the voltage-source converter, for example.

Although the example in Figure 1 is discussed in relation to a power flow directed from the DC link to the grid, the method according to the present disclosure may be used in application where the power flow is in the opposite direction. Further, the method is not limited to applications where constant power is assumed to flow through the DC-side connection of the converter. In fact, the powers through the DC-side and AC-side connections may be non-constant during the operation of the method according to the present disclosure. The integral term $x(t)$ in Equation (13) may be presented in more generic form as an integral of the power flow of the DC link. The integral may be calculated as described in Equation (8), for example. In this manner, possible changes in the external power can be taken into account in the identification. For example, in the case of an external, non-constant DC source supplying the inverter, the first power flowing to the DC link may be calculated on the basis of the voltage of the DC link and a current of the DC source.

During the observation period, the voltage response and the change in energy stored in the DC link may be stored in a memory. The voltage response may be stored in the form of samples of DC link voltage, for example. Corresponding samples of measured/estimated electrical quantities (e.g. output current and output voltage) that are used to determine the change in energy stored in the DC link may also be stored in the memory. After the observation period, the first and second set may be calculated on the basis of the stored samples. Alternatively, data points of the first and second set may be directly calculated on each sampled value during the observation period, and the calculated data points of the first and second set may be stored to the memory.

After the voltage response and the change in energy stored in the DC link have been determined, the capacitance of the DC link may be estimated on the basis of the voltage response and the change in energy. For example, the estimating of the capacitance of the DC link may comprise calculating a linear regression between the first *set* $y(k)$ and the second set $x(k)$, and determining the capacitance of the DC link on the basis of the calculated linear regression. The least squares method may be used for calculating the linear regression, for example. The input and output signals for the least squares estimation procedure, i.e. the first *set* $y(k)$ and the second *set* $x(k)$ of data points, may be calculated from Equations (4), (15), and (16), for example.

The first set $y(k)$ and the second set $x(k)$ may be pre-processed. For example, the means of the first set $y(k)$ and the second set $x(k)$ may be removed in order to achieve more accurate estimates. The means may be calculated as follows, for example:

$$\bar{y} = \frac{1}{n} \sum_{k=1}^{n} y(k), \; \bar{x} = \frac{1}{n} \sum_{k=1}^{n} x(k), \qquad (17)$$

where $n$ is the number of the collected samples. Updated first *set* $y(k)$ and second set $x(k)$ without means are $y' = y - \bar{y}$ and $x' = x - \bar{x}$, respectively.

The parameter $\beta = 1/C_{dc}$ may be estimated by the ordinary least squares method. The regression problem may be represented in a vector form as follows:

$$\mathbf{Y} = \beta \mathbf{X} + \mathbf{V}, \qquad (18)$$

where $\mathbf{Y} = [y'(1), \dots, y'(n)]^T$ represents the updated first set without its mean value, $\mathbf{X} = [x'(1), \dots, x'(n)]^T$ represents the updated second set without ist mean value, and $\mathbf{V} = [v(1), \dots, v(n)]^T$ is the residual vector. The parameter estimate $\hat{\beta}$ that minimizes the sum of the squared residuals may be obtained with the least squares method as follows

$$\hat{\beta} = \left( \mathbf{X}^T \mathbf{X} \right)^{-1} \mathbf{X}^T \mathbf{Y} = \frac{\sum_{k=1}^{n} \left[ x'(k) y'(k) \right]}{\sum_{k=1}^{n} \left[ x'(k) \right]^2} \qquad (19)$$

The capacitance estimate is then $\hat{C}_{dc} = 1/\hat{\beta}$.

In Equation (19), the dependent variable in the presented linear regression is the first set $y$ and the explanatory variable is the second set x. However, the roles of the data sets may alternatively be selected vice versa. Then, the regression problem becomes $\mathbf{X} = C_{dc}\mathbf{Y} + \mathbf{V'}$, where $\mathbf{V'}$ is the residual vector, and the capacitance estimate is given by the least the squares method

$$\hat{C}_{dc} = \left(\mathbf{Y}^{\mathrm{T}}\mathbf{Y}\right)^{-1}\mathbf{Y}^{\mathrm{T}}\mathbf{X} = \frac{\sum_{k=1}^{n}\left[x'(k)y'(k)\right]}{\sum_{k=1}^{n}\left[y'(k)\right]^{2}} \tag{20}$$

Figure 2 shows an exemplary control system of a voltage-source converter to which a excitation signal of the method according to the present disclosure can be applied. The power flow of the converter in Figure 2 corresponds to the power flow of Figure 1. In Figure 2, the voltage converter is a three-phase converter that comprises a DC-link 20, an inverter bridge 21, and a grid-side filter 22 connecting the converter to a grid 23. A modulator 24 controls the semiconductor switches in the inverter bridge 21 on the basis of a modulation voltage reference $\boldsymbol{u}_{c,ref}^{s}$.

The converter in Figure 2 further comprises a control system acting as the means for controlling the power flow. The control system performs a voltage control 25 and a current control 26 in cascade. The voltage control 25 in Figure 2 comprises a DC voltage controller 25a that controls a measured voltage $u_{dc}$ of the DC link 20 to correspond to a DC link voltage reference $u_{dc,ref}$. The DC voltage controller 25a produces an active power reference $p_{ref}$. A current reference calculation unit 25b then calculates an output current reference $i_{c,ref}$ on the basis of the active power reference $p_{ref}$. In addition, the reference calculation unit 25b may also have a reactive power reference $q_{ref}$ as an input.

The current control 26 in Figure 2 comprises a current controller 26a that controls an output current $\boldsymbol{i}_{c}^{s}$ of the converter on the basis of the output current reference $i_{c,ref}$. The current control 26 produces the modulation voltage reference $\boldsymbol{u}_{c,ref}^{s}$ for the modulator 24. The current control 26 may be implemented in a grid-voltage-oriented synchronous reference frame, for example. In Figure 2, the current control 26 comprises a first transformation unit 26b for transforming the modulation voltage reference $\boldsymbol{u}_{c,ref}^{s}$ from a synchronous reference frame to the stationary reference frame of the modulator. The synchronous reference frame rotates in synchrony with the grid voltage. The current control 26 further comprises a second transformation unit 26c for transforming the measured output current $\boldsymbol{i}_{c}^{s}$ from the stationary reference frame to the synchronous reference frame of the current controller 26. Synchronization to the grid voltage may be implemented by using a phase-locked loop or sensorless methods, for example.

In Figure 2, in order to estimate the capacitance $C_{dc}$, the DC-side converter power $p_c$ is disturbed by forcing the converter current reference to be $i_{c,ref} = i_e$, where $i_e$ is an excitation signal. In Figure 2, an excitation signal unit 28 generates the excitation signal $i_e$. Alternatively, the excitation signal $i_e$ could be applied to temporarily replace the power reference $p_{ref}$. During the feed of excitation signal, DC-voltage controller 25a is bypassed and the converter is operating in current-control (or power-control) mode.

The excitation signal may be selected such that it causes observable variations in the updated first set $y'$ and the updated second set $x'$. Moreover, the variations caused by the excitation signal may be significantly larger than variation caused by measurement errors including noise. The excitation signal may be a multi-sine or pseudo-random binary signal, for example. In one embodiment, a simple signal, which is built on rectangular pulses, is used. Figures 3a and 3b show two exemplary excitation signals having two or three pulses of different sizes and lengths. In Figures 3a and 3b, a direct component $i_{ed}$ of an excitation signal $i_e$ is altered, thus effectively changing the active power of the converter. The bias value $i_{e0} = i_{ed0} + \mathrm{j}i_{eq0}$ of the excitation signal may be selected to match with an initial operating point $i_{c0} = i_{cd0} + \mathrm{j}i_{cq0}$ before initiating the excitation signal at the beginning of the observation period.

The excitation signal $i_e$ may selected to transfer a zero-mean energy difference $\Delta W$ around the operating point. In Figure 3a, the two-pulse signal defines two areas $A_1$ and $A_2$ of equal areas on opposite sides of the initial operating point $i_{cd0}$ of the direct component $i_{ed}$ of the excitation signal $i_e$. Pulse-lengths (i.e. $t_1 - t_0$ and $t_2 - t_1$) and amplitudes (i.e. $i_{e1}$ and $i_{e2}$) may be selected to fulfil the area condition and to generate observable changes in $x'$ and $y'$. In the case of the three-pulse signal shown in Figure 3b, the sum of the areas $A_1$, $A_2$, and $A_3$ defined by the excitation with respect to the bias level $i_{cd0}$ may be zero (i.e. $A_1 - A_2 + A_3 = 0$) in order to keep the mean of energy difference zero.

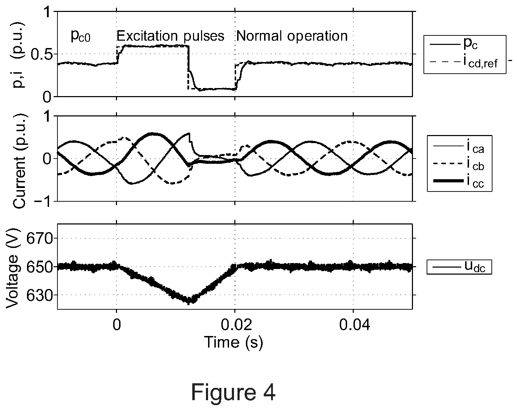

Figure 4 shows an exemplary excitation signal according to the present disclosure during normal operation of a voltage-source converter. The converter is a three-phase, grid-connected voltage-source converter with a 12.5 kVA nominal power. The top graph in Figure 4 shows a direct component $i_{cd,ref}$ of the output current reference of the converter with a dashed line and the output power $p_c$ at the AC side with a solid line. The direct component $i_{cd,ref}$ and the output power $p_c$ are shown in per-units (p.u.), i.e. as percentages of the nominal current and power, respectively. Before (and after) the excitation signal in Figure 4, the converter is feeding 5 kW of power to the grid and the direct component is at 10 A.

The middle graph shows the phase currents of the converter as per-units. The bottom graph shows the voltage response of the DC link voltage $u_{dc}$ to the excitation signal. In Figure 4, the excitation signal is applied at time instant 0. Driven by the excitation signal, the direct component $i_{cd,ref}$ of the current reference first rises by 5 A from its initial level. The direct component $i_{cd,ref}$ then falls to level 7.5 A below the initial level. As a result, an observable variation is induced to the DC link voltage, as shown in the bottom graph of Figure 4. The method according to the present disclosure is not limited to the above-described levels of the current reference. Depending on the application and the noise levels in the application, smaller or larger amplitudes of the excitation signal may be used.

The method according to the present disclosure may be utilized for monitoring a condition of a DC link of a voltage-source converter, for example. Such a monitoring method may comprise estimating a capacitance of the DC link by using an estimation method according to the present disclosure, and determining the condition of the DC link on the basis of the estimated capacitance. For example, the monitoring method may determine an initial value of the estimated capacitance by using the estimation method according to the present disclosure, and store the initial value to a memory. The monitoring method may then (periodically) detect a present value of the estimated capacitance by using the estimation method, and compare the present value to the initial value. If the present value differs from the initial value more than a set limit, a notification may be issued. The notification may indicate a fault or an appropriate time for replacing the capacitor before a failure, for example.

If the capacitance estimate is used in condition monitoring, the temperature of the capacitor during the estimation may also be considered, since the capacitance value may be highly dependent on temperature. Beside the condition monitoring, the estimated capacitance value may be useful in adaptive control tuning.

In multi-drive systems, several inverters may be connected to a common DC-link, and an active-front-end rectifier may regulate the DC-link voltage. In these systems, the capacitance of the DC-link may vary significantly, if the number of the inverters connected to the common DC-link is changing. The varying capacitance changes the system dynamics and may cause troubles for DC-link voltage control and the system stability. Therefore, the real-time estimation of the DC-link capacitance may be very valuable enabling adaptation of the controller parameters.

The present disclosure further describes an apparatus for estimating a capacitance of a DC link of a three-phase voltage-source converter that comprises means for controlling the power flow of the DC link. The apparatus comprises means to carry out the method according to the present disclosure. For example, the voltage-source converter may act as the apparatus for estimating the capacitance. The estimation method according to the present disclosure may be implemented on a control unit of the voltage-source converter, for example. The control unit may comprise computing means, such as a processor, an FPGA or an ASIC, and a memory that act as the means to carry out the method according to the present disclosure.

The voltage-source converter, or its control unit, may further implement a control system for monitoring the condition of the DC link. The monitoring system may implement a monitoring method as described above, for example.

It will be obvious to a person skilled in the art that, as the technology advances, the inventive concept can be implemented in various ways. The invention and its embodiments are not limited to the examples described above but may vary within the scope of the claims.

## Claims

1. A method for estimating a capacitance ($C_{dc}$) of a DC link (20) of a three-phase voltage-source converter (21), wherein the voltage-source converter comprises means for controlling a power flow of the DC link responsive to a control reference ($p_{ref}$), the power flow representing a difference between a first power ($p_{dc}$) flowing to the DC link and a second power ($p_{sw}$) flowing out from the DC link, and wherein the method comprises
generating an excitation signal with a plurality of levels of the power flow,
using the excitation signal temporarily as the control reference in order to control a temporary change to the power flow,
monitoring a voltage response induced to the DC link voltage ($u_{dc}$) by the temporary change in the power flow,
calculating a change in energy (W) stored in the DC link caused by the temporary change in the power flow, and
estimating the capacitance of the DC link on the basis of the voltage response and the change in energy stored in the DC link,
wherein the monitoring of the voltage response comprises
sampling the DC link voltage in order to determine the voltage response during an observation period, and
forming a first set of data points on the basis of the voltage response, wherein each data point represents a difference between a square of a sampled DC link voltage and a square of an initial value of the DC link voltage at the beginning of the observation period, and
wherein the calculating of the change in the energy stored in the DC link comprises
determining an initial power flow of the DC link at the beginning of the observation period,
calculating values of the power flow during the observation period,
forming a second set of data points, wherein each data point represents an integral of the calculated values of the power flow of the DC link.

2. A method according to claim 1, wherein the first power is assumed to be constant and the calculating of the values of the power flow comprises
approximating a level of the first power on the basis of an initial level of the second power at the beginning of the observation period.

3. A method according to claim 1 or 2, wherein the estimating of the capacitance of the DC link comprises,
calculating a linear regression between the first set and the second set,
determining the capacitance of the DC link on the basis of the calculated linear regression.

4. A method according to claim 3, wherein least squares method is used for calculating the linear regression.

5. A method according to any one of preceding claims, wherein the means for controlling the power flow comprise a cascade control of the DC link voltage and an output current of the voltage-source converter.

6. A method according to claim 5, wherein
the voltage-source converter is configured to supply a grid from a DC source,
the first power flowing to the DC link is assumed to have a predetermined value or is calculated on the basis of the voltage of the DC link and a current of the DC source, and
the second power flowing out from the DC link is calculated on the basis of a voltage reference for a modulator of the voltage-source converter and an output current of the voltage-source converter.

7. A method according to claim 5 or 6, wherein the control reference is a current reference or a power reference of the cascade control.

8. A method according to any one of the preceding claims, wherein the excitation signal is configured to induce a zero-mean energy difference to the energy stored in the DC link.

9. A method according to any one of the preceding claims, wherein the excitation signal is in the form of a multi-sine signal or a pseudo-random binary signal.

10. A method for monitoring a condition of a DC link of a voltage-source converter, wherein the method comprises estimating a capacitance of the DC link by using a method according to any one of preceding claims, and determining the condition of the DC link on the basis of the estimated capacitance.

11. An apparatus for estimating a capacitance ($C_{dc}$) of a DC link (20) of a voltage-source converter (21), wherein the voltage-source converter comprises means (25, 26) configured to control a power flow of the DC link, the power flow representing a difference between a first power ($p_{dc}$) flowing to the DC link and a second power ($p_{sw}$) flowing out from the DC link, and wherein the apparatus comprises means configured to carry out a method according to any one of claims 1 to 10.

12. An apparatus according to claim 11, wherein the apparatus is a voltage-source converter (21).

**Patentansprüche**

1. Verfahren zum Schätzen einer Kapazität ($C_{dc}$) eines Gleichstromzwischenkreises (20) eines Dreiphasenspannungsquellenumsetzers (21), wobei der Spannungsquellenumsetzer Mittel zum Steuern eines Leistungsflusses des Gleichstromzwischenkreises als Reaktion auf einen Steuerbezug ($p_{ref}$) umfasst, der Leistungsfluss eine Differenz zwischen einer ersten Leistung ($p_{dc}$), die zum Gleichstromzwischenkreis fließt, und einer zweiten Leistung ($p_{sw}$), die aus dem Gleichstromzwischenkreis fließt, repräsentiert und das Verfahren Folgendes umfasst:

Erzeugen eines Erregungssignals mit mehreren Pegeln des Leistungsflusses,

Verwenden des Erregungssignals vorübergehend als den Steuerbezug, um eine vorübergehende Änderung des Leistungsflusses zu steuern,

Überwachen einer Spannungsantwort, die durch die vorübergehende Änderung des Leistungsflusses in die Gleichstromzwischenkreisspannung ($u_{dc}$) induziert wird,

Berechnen einer Änderung der Energie (W), die im Gleichstromzwischenkreis gespeichert ist, die durch die vorübergehende Änderung des Leistungsflusses bewirkt wird, und

Schätzen der Kapazität des Gleichstromzwischenkreises auf der Grundlage der Spannungsantwort und der Änderung der Energie, die im Gleichstromzwischenkreis gespeichert ist, wobei

das Überwachen der Spannungsantwort Folgendes umfasst:

Abtasten der Gleichstromzwischenkreisspannung, um die Spannungsantwort während eines Beobachtungszeitraums zu bestimmen, und

Bilden eines ersten Satzes von Datenpunkten auf der Grundlage der Spannungsantwort, wobei jeder Datenpunkt eine Differenz zwischen einem Quadrat einer abgetasteten Gleichstromzwischenkreisspannung und einem Quadrat eines Anfangswerts der Gleichstromzwischenkreisspannung zu Beginn des Beobachtungszeitraums repräsentiert, und wobei

das Berechnen der Änderung der Energie, die im Gleichstromzwischenkreis gespeichert ist, Folgendes umfasst:

Bestimmen eines anfänglichen Leistungsflusses des Gleichstromzwischenkreises zu Beginn des Beobachtungszeitraums,

Berechnen von Werten des Leistungsflusses während des Beobachtungszeitraums und

Bilden eines zweiten Satzes von Datenpunkten, wobei jeder Datenpunkt ein Integral der berechneten Werte des Leistungsflusses des Gleichstromzwischenkreises umfasst.

2. Verfahren nach Anspruch 1, wobei die erste Leistung als konstant angenommen wird und das Berechnen der Werte des Leistungsflusses Folgendes umfasst:

Annähern eines Pegels der ersten Leistung auf der Grundlage eines anfänglichen Pegels der zweiten Leistung zu Beginn des Beobachtungszeitraums.

3. Verfahren nach Anspruch 1 oder 2, wobei das Schätzen der Kapazität des Gleichstromzwischenkreises Folgendes umfasst:

Berechnen einer linearen Regression zwischen dem ersten Satz und dem zweiten Satz und

Bestimmen der Kapazität des Gleichstromzwischenkreises auf der Grundlage der berechneten linearen Regression.

4. Verfahren nach Anspruch 3, wobei das Verfahren der kleinsten Quadrate verwendet wird, um die lineare Regression zu berechnen.

5. Verfahren nach einem der vorhergehenden Ansprüche, wobei die Mittel zum Steuern des Leistungsflusses eine Kaskadensteuerung der Gleichstromzwischenkreisspannung und eines Ausgangsstroms des Spannungsquellenumsetzers umfassen.

6. Verfahren nach Anspruch 5, wobei

der Spannungsquellenumsetzer konfiguriert ist, ein Netz von einer Gleichstromquelle zu versorgen,

die erste Leistung, die zum Gleichstromzwischenkreis fließt, zu einem vorgegebenen Wert angenommen wird oder auf der Grundlage der Spannung des Gleichstromzwischenkreises und eines Stroms der Gleichstromquelle berechnet wird und

die zweite Leistung, die aus dem ersten Gleichstromzwischenkreis fließt, auf der Grundlage eines Spannungsbezugs für einen Modulator des Spannungsquellenumsetzers und eines Ausgangsstroms des Spannungsquellenumsetzers berechnet wird.

7. Verfahren nach Anspruch 5 oder 6, wobei der Steuerbezug ein Strombezug oder ein Leistungsbezug der Kaskadensteuerung ist.

8. Verfahren nach einem der vorhergehenden Ansprüche, wobei das Erregungssignal konfiguriert ist, eine mittelwertfreie Energiedifferenz zur Energie, die im Gleichstromzwischenkreis gespeichert ist, induziert wird.

9. Verfahren nach einem der vorhergehenden Ansprüche, wobei das Erregungssignal in Form eines Mehrfachsinussignals oder eines pseudozufälligen Binärsignals vorliegt.

10. Verfahren zum Überwachen eines Zustands eines Gleichstromzwischenkreises eines Spannungsquellenumsetzers, wobei das Verfahren Folgendes umfasst:

Schätzen einer Kapazität des Gleichstromzwischenkreises unter Verwendung eines Verfahrens nach einem der vorhergehenden Ansprüche und
Bestimmen des Zustands des Gleichstromzwischenkreises auf der Grundlage der geschätzten Kapazität.

11. Vorrichtung zum Schätzen einer Kapazität ($C_{dc}$) eines Gleichstromzwischenkreises (20) eines Dreiphasenspannungsquellenumsetzers (21), wobei der Spannungsquellenumsetzer Mittel (25, 26) umfasst, die zum Steuern eines Leistungsflusses des Gleichstromzwischenkreises konfiguriert sind, der Leistungsfluss eine Differenz zwischen einer ersten Leistung ($p_{dc}$), die zum Gleichstromzwischenkreis fließt, und einer zweiten Leistung ($p_{sw}$), die aus dem Gleichstromzwischenkreis fließt, repräsentiert und die Vorrichtung Mittel umfasst, die konfiguriert sind, das Verfahren nach einem der Ansprüche 1 bis 10 auszuführen.

12. Vorrichtung nach Anspruch 11, wobei die Vorrichtung ein Spannungsquellenumsetzer (21) ist.

**Revendications**

1. Procédé d'estimation d'une valeur de capacité ($C_{dc}$) d'une liaison C.C. (20) d'un convertisseur tension-source triphasé (21), le convertisseur tension-source comprenant un moyen pour commander un flux de puissance de la liaison C.C. en réponse à une référence de commande ($p_{ref}$), le flux de puissance représentant une différence entre une première puissance ($P_{dc}$) allant à la liaison C.C. et une seconde puissance ($P_{sw}$) sortant de la liaison C.C., et le procédé comprenant

la génération d'un signal d'excitation avec une pluralité de niveaux du flux de puissance,
l'utilisation temporaire du signal d'excitation en tant que référence de commande afin de commander un changement temporaire du flux de puissance,
la surveillance d'une réponse de tensions induite dans la tension de liaison C.C. ($u_{dc}$) par le changement temporel dans le flux de puissance,
le calcul d'un changement de l'énergie (W) stockée dans la liaison C.C. causé par le changement temporaire du flux de puissance, et
l'estimation de la valeur de capacité de la liaison C.C. en fonction de la réponse de tension et du changement de l'énergie stockée dans la liaison C.C.,
dans lequel la surveillance de la réponse de tension comprend
l'échantillonnage de la tension de liaison C.C. afin de déterminer la réponse de tension durant une période d'observation, et
la formation d'un premier ensemble de points de données en fonction de la réponse de tension, dans lequel chaque point de données représente une différence entre un carré d'une tension de liaison C.C. échantillonnée et un carré d'une valeur initiale de la tension de liaison C.C. au début de la période d'observation, et
dans lequel le calcul du changement de l'énergie stockée dans la liaison C.C. comprend
la détermination d'un flux de puissance initial de la liaison C.C. au début de la période de conservation,
le calcul de valeurs du flux de puissance durant la période d'observation,
la formation d'un second ensemble de points de données, dans lequel chaque point de données représente une intégrale des valeurs calculées du flux de puissance de la liaison C.C..

2. Procédé selon la revendication 1, dans lequel la première puissance est supposée être constante et le calcul des valeurs du flux de puissance comprend
l'approximation d'un niveau de la première puissance en fonction d'un niveau initial de la seconde puissance au début de la période d'observation.

3. Procédé selon la revendication 1 ou 2, dans lequel l'estimation de la valeur de capacité de la liaison C.C. comprend,
le calcul d'une régression linéaire entre le premier ensemble et le second ensemble,
la détermination de la valeur de capacité de la liaison C.C. en fonction de la régression linéaire calculée.

**4.** Procédé selon la revendication 3, dans lequel un procédé des moindres carrés est utilisé pour calculer la régression linéaire.

**5.** Procédé selon l'une quelconque des revendications précédentes, dans lequel le moyen de commande du flux de puissance comprend une commande en cascade de la tension de liaison C.C. et d'un courant de sortie du convertisseur tension-source.

**6.** Procédé selon la revendication 5, dans lequel
le convertisseur tension-source est configuré pour alimenter un réseau à partir d'une source C.C.,
la première puissance passant à la liaison C.C. est supposée avoir une valeur prédéterminée ou est calculée en fonction de la tension de la liaison C.C. et d'un courant de la source C.C., et
la seconde puissance sortant de la liaison C.C. est calculée en fonction d'une référence de tension d'un modulateur du convertisseur de tension-source et d'un courant de sortie du convertisseur tension-source.

**7.** Procédé selon la revendication 5 ou 6, dans lequel la référence de commande est une référence de courant ou une référence de puissance de la commande en cascade.

**8.** Procédé selon l'une quelconque des revendications précédentes, dans lequel le signal d'excitation est configuré pour induire une différence d'énergie de moyenne nulle dans l'énergie stockée dans la liaison C.C..

**9.** Procédé selon l'une quelconque des revendications précédentes, dans lequel le signal d'excitation a la forme d'un signal multi-sinusoïdal ou d'un signal binaire pseudo-aléatoire.

**10.** Procédé de surveillance d'un état d'une liaison C.C. d'un convertisseur tension-source, le procédé comprenant l'estimation d'une valeur de capacité de la liaison C.C. en utilisant un procédé selon l'une quelconque des revendications précédentes, et
la détermination de l'état de la liaison C.C. en fonction de la valeur de capacité estimée.

**11.** Appareil d'estimation d'une valeur de capacité ($C_{dc}$) d'une liaison C.C. (20) d'un convertisseur tension-source (21), le convertisseur tension-source comprenant un moyen (25, 26) configuré pour commander un flux de puissance de la liaison C.C. en réponse à une référence de commande ($p_{ref}$), le flux de puissance représentant une différence entre une première puissance ($P_{dc}$) allant à la liaison C.C. et une seconde puissance ($P_{sw}$) sortant de la liaison C.C., et l'appareil comprenant un moyen configuré pour mettre en œuvre le procédé selon l'une quelconque des revendications 1 à 10.

**12.** Appareil selon la revendication 11, dans lequel l'appareil est un convertisseur tension-source (21).

EP 3 223 023 B1

Figure 1

Figure 2

Figure 3a

Figure 3b

Figure 4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001309561 B
- KR 101605990
- KR 101553480